# EUROPÄISCHE PATENTSCHRIFT

(11) **EP 1 183 405 B1**
(45) Veröffentlichungstag und Bekanntmachung des Hinweises auf die Patenterteilung: **20.08.2003**
(21) Anmeldenummer: 00910483.7
(22) Anmeldetag: 29.03.2000
(51) Int. Cl.: C23C 16/44, C23C 14/56

(54) **VERFAHREN ZUM VAKUUMBEHANDELN VON WERKSTÜCKEN UND VAKUUMBEHANDLUNGSANLAGE**
METHOD FOR VACUUM TREATMENT OF WORKPIECES AND VACUUM TREATMENT FACILITY
PROCEDE POUR TRAITER DES PIECES SOUS VIDE ET INSTALLATION DE TRAITEMENT SOUS VIDE CORRESPONDANTE

(30) Priorität: 16.04.1999 CH 70199
(43) Veröffentlichungstag der Anmeldung: 06.03.2002
(73) Patentinhaber: Unaxis Balzers Aktiengesellschaft, 9496 Balzers (LI)
(72) Erfinder: SCHAEFER, Franz, Josef, A-6830 Rankweil (AT); WEINZERL, Helfried, A-6800 Feldkirch (AT)
(74) Vertreter: Troesch Scheidegger Werner AG
(86) Internationale Anmeldenummer: CH0000181
(87) Internationale Veröffentlichungsnummer: WO00063460

(56) Entgegenhaltungen:
- EP-A- 0 590 243
- WO-A-98/28459
- US-A- 3 649 339
- US-A- 5 641 960
- L.I. MAISSEL ET AL: "HANDBOOK OF THIN FILM TECHNOLOGY" 1970 , MCGRAW-HILL , US XP002022430 6274 Seite 2-8, Zeile 18 -Seite 2-9, Zeile 18
- PATENT ABSTRACTS OF JAPAN vol. 007, no. 232 (C-190), 14. Oktober 1983 (1983-10-14) & JP 58 123872 A (MATSUSHITA DENKI SANGYO KK), 23. Juli 1983 (1983-07-23)
- LIAN S ET AL: "PHOTO-ENHANCED CHEMICAL VAPOR DEPOSITION: SYSTEM DESIGN CONSIDERATIONS" JOURNAL OF VACUUM SCIENCE AND TECHNOLOGY: PART A,US,AMERICAN INSTITUTE OF PHYSICS. NEW YORK, Bd. 11, Nr. 6, Seite 2914-2923 XP000412878 ISSN: 0734-2101

## Beschreibung

Die vorliegende Erfindung betrifft ein Verfahren zum zyklischen Vakuumbehandeln von Werkstücken nach dem Oberbegriff von Anspruch 1.

Sie betrifft im weiteren eine Vakuumbehandlungsanlage nach dem Oberbegriff von Anspruch 7.

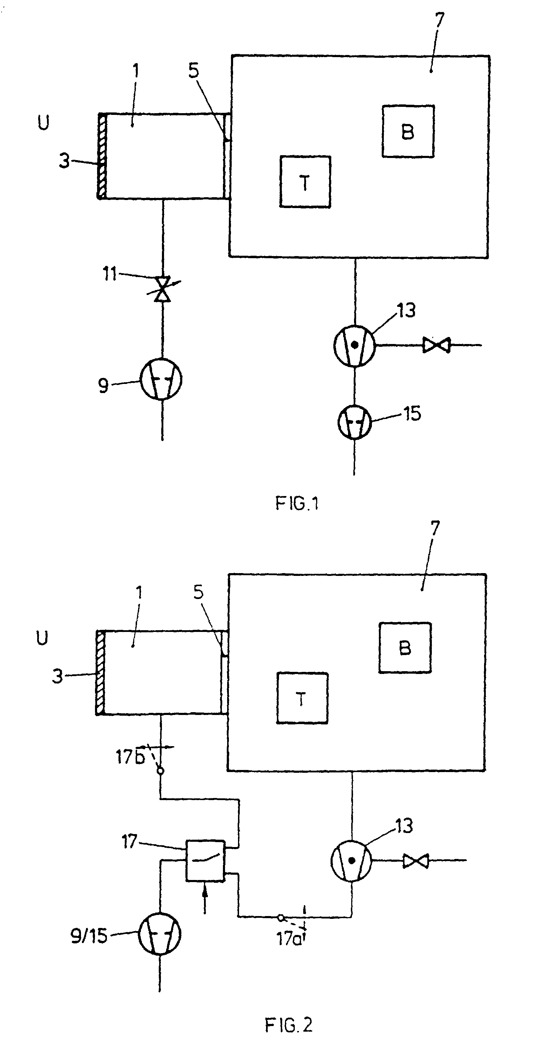

In Fig. 1 ist in Form eines Funktionsblockdiagramms eine derartige vorbekannte Anordnung dargestellt, woraus sich auch ohne weiteres für den Fachmann das erwähnte vorbekannte Werkstückbehandlungsverfahren ergibt.

Gemäss Fig. 1 ist eine Schleusenkammer 1 mit Schleusenventil 3 gegen die Umgebung U, mit Schleusenventil 5 gegen eine Vakuumkammeranordnung 7, vorgesehen. Die Vakuumkammeranordnung 7 kann dabei, in Minimalkonfiguration, eine einzige Behandlungskammer B umfassen oder aber eine oder mehrere Transportkammer(n), mit letzterer oder letzteren wirkverbunden, wiederum eine oder mehrere Behandlungskammer(n) B sowie gegebenenfalls weiteren Schleusenkammern. Dies, je nach dem, wie komplex und vielschrittig die an Werkstücken durchzuführende Behandlung ist. Wie dem Fachmann ohne weiteres geläufig, werden die Werkstücke bei geschlossenem Schleusenventil 5 und geöffnetem Schleusenventil 3 in die Schleusenkammer 1 eingeführt, worauf das Schleusenventil 3 geschlossen und die Schleusenkammer 1 mittels einer Schleusenpumpe 9, wie beispielsweise einer ein- oder mehrstufigen Drehschieberpumpe und über ein Ventil 11, evakuiert wird.

Grundsätzlich wird an der Vakuumkammeranordnung 7 mindestens eine Turbovakuumpumpe 3 vorgesehen, welche mindestens die eine Behandlungskammer abpumpt, gegebenenfalls auch kombiniert gemeinsam mit einer dieser zugeordneten Transportkammer. Sind mehrere Behandlungskammern vorgesehen, die unabhängig voneinander zu pumpen sind, so können durchaus mehrere Turbovakuumpumpen 13 vorgesehen sein.

Der mindestens einen mit der Vakuumkammeranordnung 7 wirkverbundenen Turbovakuumpumpe 13 ist hochdruckseitig eine Vorvakuumpumpe 15 nachgeschaltet, um an der Turbovakuumpumpe 13 den geforderten Vordruck zu erzeugen.

Es ist Aufgabe der vorliegenden Erfindung, das Verfahren eingangs genannter Art so weiterzubilden, dass es kostengünstiger wird, dass es weniger störungsanfällig wird, weiter die Anlage obengenannter Art entsprechend zu vereinfachen, wartungsgenügsamer und kompakter zu realisieren, unter Einhalt möglichst kurzer Zykluszeiten. Dies wird durch das eingangs genannte Verfahren gelöst, nach dem Kennzeichen von Anspruch 1 ausgeführt.

Zur Lösung der genannten Aufgabe zeichnet sich weiter die Vakuumbehandlungsanlage eingangs genannter Art nach dem Kennzeichen von Anspruch 7 aus.

Es wird darauf verwiesen, dass aus der US-A-5 641 960 ein Verfahren zum gleichzeitigen Vakuumbehandeln mehrerer Werkstücke bekannt ist bei dem, aus einer Schleusenkammer mit einem Werkstückmagazin für mehrere Werkstücke, erst mehrere dieser Werkstück in eine Hochvakuum-Behandlungskammer eingeführt werden und diese dann darin, unter Hochvakuumbedingungen, einer Inspektionsuntersuchung unterzogen werden. Das Hochvakuum in der Behandlungskammer wird mittels einer durch eine Drehschieberpumpe unterstützte Turbomolekularpumpe erzeugt. Mit Hilfe einer Ventilumschaltanordnung wird die Drehschieberpumpe auch zur Evakuierung der Schleusenkammer eingesetzt.

Aus der EP 0 590 243 ist weiter bekannt, an einer Vorrichtung zum Ein- und Ausschleusen von Werkstücken, die Zykluszeiten durch mechanische Antriebsmassnahmen zu verkürzen.

Das erfindungsgemässe Verfahren wie auch die erfindungsgemässe Anordnung eignen sich ganz besonders gut für die Behandlung, insbesondere Beschichtung, von scheibenförmigen Werkstücken, insbesondere von Speicherdisks, dabei ganz besonders von optischen Datenspeicherdisks.

Die Erfindung wird anschliessend anhand von Figuren erläutert. Es zeigen:
- Fig. 2: ausgehend von einer Darstellung gemäss Fig. 1, die grundsätzliche, erfindungsgemässe Weiterbildung der Vakuumanlage, zur Realisation des erfindungsgemässen Herstellungsverfahrens,
- Fig. 3: schematisch, die Realisationsform einer hochkompakten, erfindungsgemässen Vakuumbehandlungsanlage in einer bevorzugten Ausführungsform.

In Fig. 2 ist dieselbe Vakuumbehandlungsanlage wie in Fig. 1 dargestellt, unter Verwendung derselben Bezugszeichen, jedoch wie nachfolgend ausgeführt wird, erfindungsgemäss weitergebildet.

Gemäss Fig. 2 entfällt erfindungsgemäss die der Turbovakuumpumpe 13 hochdruckseitig nachgeschaltete Vorvakuumpumpe. An ihrer statt wird die Schleusenkammerpumpe 9 auch als Vorpumpe der Turbovakuumpumpe 13 eingesetzt. Deshalb ist in Fig. 2 die kombiniert eingesetzte Schleusenkammer-/Vorvakuum-Pumpe mit dem kombinierten Bezugszeichen 9/15 bezeichnet. Signaltechnisch ist mithin die Niederdruckseite der Schleusenkammer-/Vorvakuumpumpe 9/15 über eine gesteuerte Umschalteinrichtung 17 sowohl mit der Schleusenkammer wie auch mit der Hochdruckseite der Turbovakuumpumpe 13 wirkverbunden. Beim Laden eines Werkstückes in die Schleusenkammer 1 wird, zum Abpumpen der Schleusenkammer 1, über die Umschalteinheit 17, der Tiefdruckeingang der Schleusenkammer-/Vorvakuumpumpe 9/15 vom Hochdruckanschluss der Turbovakuumpumpe 13 abgetrennt und mit der Schleusenkammer wirkverbunden. Nach Abpumpen der Schleusenkammer 1 auf Übergabedruck an die Vakuumkammeranordnung 7 wird der Tiefdruckeingang der Schleusenkammer-/Vorvakuumpumpe 9/15 über die erwähnte Umschalteinrichtung 17 mit der Hochdruckseite der Turbovakuumpumpe 13 wirkverbunden.

Es ist durchaus möglich, die Umschaltanordnung 17, wie gestrichelt bei 17a und 17b dargestellt, mittels unabhängig voneinander ansteuerbaren Ventilen zu realisieren, oder aber mittels eines Zweiwegventils, wie die Einrichtung 17 auch dargestellt ist.

Die Steuerung der erwähnten Wirkverbindungen kann dabei druckgesteuert erfolgen, beispielsweise durch Messen des Druckes in der Schleusenkammer 1 und Umschalten auf Vorpumpenbetrieb der Schleusenkammer-/Vorvakuumpumpe 9/15 bei Erreichen eines vorgegebenen Druckwertes oder kann in vorgegebenem Rhythmus gemäss voreruierter Zyklen erfolgen.

Bevorzugterweise wird eine Turbovakuumpumpe 13 eingesetzt, die hochdruckseitig gegen einen möglichst hohen Druck arbeiten kann, bevorzugterweise von mindestens 1 mbar, insbesondere bevorzugt von mindestens 10 mbar. Hierzu eignen sich besonders Turbodrag-Pumpen bzw. Turbopumpen kombiniert mit Holweck-Stufen am Pumpenausgang. Als Schleusenkammer-/Vorvakuum-Pumpe wird weiterhin bevorzugt eine ein- oder mehrstufige Drehschieberpumpe eingesetzt.

Bei Einsatz der obgenannten, bevorzugt eingesetzten Turbovakuumpumpe 13 erlaubt dies sogar, eine sehr "saubere" Membranpumpe als Schleusenkammer-/Vorvakuumpumpe einzusetzen.

Im weiteren sollte die Schleusenkammer 1 möglichst rasch abgepumpt werden. Dies, damit hochdruckseitig die Turbovakuumpumpe 13 nicht zu lange in die dann geschlossene Wirkverbindung zur Umschaltanordnung 17 bzw. einem geschlossenen Ventil 17a wirken muss. Darnach bemisst sich einerseits die Leistung der vorgesehenen Schleusenkammer-/Vorvakuum-Pumpe 9/15, aber insbesondere das Volumen der Schleusenkammer 1. Letzteres sollte möglichst klein gewählt werden, vorzugsweise sollte das Verhältnis des Schleusenkammervolumens zu dem von der vorgesehenen Turbovakuumpumpe 13 abgepumpten Volumen höchstens 1:40, vorzugsweise gar höchstens 1:100, gewählt werden.

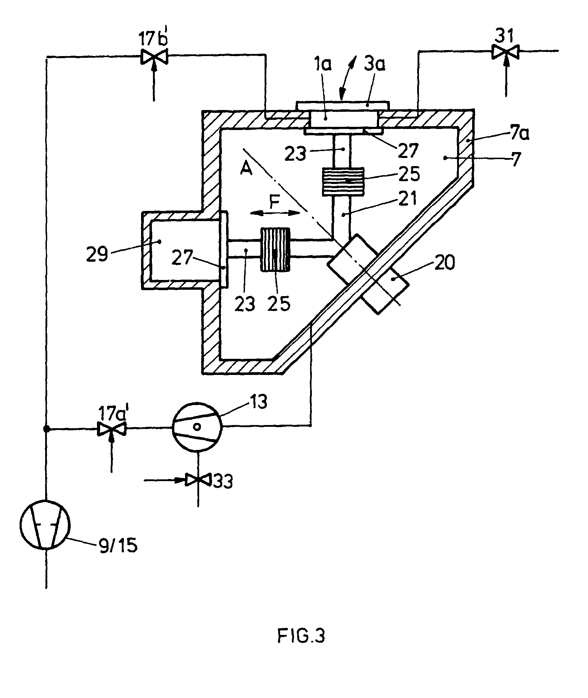

In Fig. 3 ist schematisch eine bevorzugte, höchst kompakte, erfindungsgemässe Vakuumbehandlungsanlage dargestellt zum erfindungsgemässen Vakuumbehandeln von Werkstücken, insbesondere kreisschreibenförmiger Werkstücke, wie z.B. und bevorzugt von Datenspeicherscheiben.

In einem Gehäuse 7a der Vakuumkammeranordnung 7 ist, um eine Achse A mittels eines Antriebs 20 getrieben drehbeweglich, eine Transporteinrichtung 21 vorgesehen, mit bezüglich der Drehachse A gewinkelten Transportarmen 23. Die Transportarme 23 sind mittels zugeordneter Linearantriebe, wie bei 25 dargestellt, gekapselt, ausfahrbar bzw. rückholbar, wie mit F dargestellt. Sie tragen endständig Werkstückträgerplatten 27 für (nicht dargestellt) Werkstückscheiben. Die Vakuumkammeranordnung 7 umfasst, am Gehäuse 7a z.B. angeflanscht, eine Bearbeitungsstation 29, wie beispielsweise eine Sputterstation.

Das Volumen einer vorgesehenen Schleusenkammer 1a ist dadurch minimalisiert, dass sie praktisch in die Wandstärke der Wandung des Gehäuses 7a integriert ist. Diese bereits vorgängig anhand von Fig. 2 besprochene Minimalisierung des Schleusenkammervolumens ist in dem in Fig. 3 dargestellten Umfang insbesondere in Kombination mit der Behandlung, so insbesondere der Beschichtung, von scheibenförmigen Werkstücken, so insbesondere von Speicherscheiben, dabei ganz besonders von optischen Datenspeicherscheiben, möglich.

Mit der dargestellten, erfindungsgemässen Anlage, insbesondere nach Figur 3, wurden, als Beispiel, Zykluszeiten von weniger als 2 sec. bei der CD-Herstellung bzw. der Herstellung optischer Speicherscheiben erreicht, im konkreten von 1,8 sec. bei einer Schleusungszeit von 0,4 sec.

Grundsätzlich wird bevorzugt vorgeschlagen, dass die Teilzeitspanne der Zykluszeit "Transport und Behandlung" mindestens 50 % der Gesamt-Zykluszeit beträgt, vorzugsweise mindestens 60 %, oder, ausgedrückt in bezug auf die "Schleusen-Zeit", mindestens 300 %.

Es bezeichnet 3a das äussere Schleusenventil, das innere wird durch die Werkstückträgerplatte 27 am jeweiligen Transportarm 23 gebildet. Durch Rotation der Transporteinrichtung 21 um die Achse A werden die vorgesehenen Transportarme bzw. die rückgeholten Trägerplatten 27 auf Schleusenkammer 1a und Bearbeitungsstation 29 erst ausgerichtet. Durch Ausfahren der Arme werden die entsprechenden Stationen 1a, 29 abgedichtet, sei dies durch Erstellen einer Druckstufe, wie mittels Labyrinthdichtung, sei dies vakuumdicht, z.B. formschlüssig. Einerseits wird dann an der Schleusenkammer 1a durch Öffnen des Schleusenventils 3a ein Werkstück ein- oder ausgegeben, während gleichzeitig an der den Erfordernissen entsprechend verschlossenen bzw. gedichteten Bearbeitungsstation 29 die Werkstückbearbeitung erfolgt.

Eine Anordnung dieser Art ist vollumfänglich in der EP-A-0 518 109 entsprechend der US-A-5 245 736 derselben Anmelderin wie vorliegender Anmeldung beschrieben.

Wie ersichtlich, wird bevorzugterweise die anhand von Fig. 2 erläuterte Umschalteinrichtung 17 mittels je in die Verbindungsleitung eingeschalteter Ventile 17b' bzw. 17a' realisiert. In der dargestellten Ausführungsform pumpt die Turbovakuumpumpe 13 sowohl Innenvolumen der Transportkammer wie auch der Prozesskammer ab. Es wurde ein Verhältnis der Volumina von Schleusenkammer 1a zu dem von der Turbovakuumpumpe 13 abgepumpten Volumen von 1:110 realisiert.

Es bezeichnen in Fig. 3 weiter 31 ein Flutungsventil für die Schleusenkammer 1a, 33 das bereits in den Fig. 1 und 2 eingezeichnete Flutungsventil für die Turbovakuumpumpe 13.

## Patentansprüche

1. Verfahren zum zyklischen Vakuumbehandeln von Werkstücken, bei dem jeweils ein Werkstück
a) in eine gegen Umgebungsatmosphäre (U) geöffnete Schleusenkammer (1) eingeführt wird,
b) die Schleusenkammer (1) abgepumpt wird, nachdem sie gegen die erwähnte Umgebung geschlossen (3) worden ist,
c) die Schleusenkammer in eine mindestens zum Teil abgepumpte Vakuumkammeranordnung (7) geöffnet wird,
d) das Werkstück aus der Schleusenkammer (1) in die Anordnung (7) transportiert wird,
e) das Werkstück in der Anordnung (7) behandelt wird,
f) das Werkstück von der Anordnung (7) in die Schleusenkammer (1) rücktransportiert wird.
g) die Schleusenkammer (1) gegen die Anordnung (7) geschlossen (5), dann geflutet (25) wird.
h) das behandelte Werkstück aus der gefluteten Schleusenkammer (1) in die Umgebung (U) weggeführt wird,
wobei man:
- mindestens einen Teil der Anordnung (7) mittels einer Turbovakuumpumpe (13) mit hochdruckseitig damit wirkverbundener Vorvakuumpumpe (15) abpumpt und
- die Schleusenkammer (1) mittels einer Schleusenkammerpumpe (9),
**dadurch gekennzeichnet, dass** man, als Vorvakuumpumpe (15), die Schleusenkammerpumpe (9) mit der Turbovakuumpumpe (13) wirkverbindet und das Verhältnis des zu pumpenden Schleusenkammervolumens und des mittels der Turbovakuumpumpe (13) zu pumpenden Volumens höchstens 1:40 ist.

2. Verfahren nach Anspruch 1, **dadurch gekennzeichnet, dass** man als Schleusenkammer- und Vorvakuumpumpe (9/15) eine ein- oder mehrstufige Drehschieberpumpe einsetzt oder eine Membranpumpe.

3. Verfahren nach einem der Ansprüche 1 oder 2, **dadurch gekennzeichnet, dass** die Turbovakuumpumpe (13) hochdruckseitig gegen einen Druck von mindestens 1 mbar, vorzugsweise von mindestens 10 mbar, arbeiten kann, vorzugsweise eine Turbo-Drag- bzw. Turbopumpe mit Holweckstufe ist.

4. Verfahren nach einem der Ansprüche 1 bis 3, **dadurch gekennzeichnet, dass** man zum Abpumpen der Schleusenkammer (1) niederdruckseitig die Vorvakuumpumpe (9/15) von ihrer Wirkverbindung mit der Turbovakuumpumpe (13) abtrennt (17, 17a), darnach zum Abpumpen des Teils der Anordnung die Vorvakuumpumpe (9/15) von der Schleusenkammer (1) abtrennt (17, 17b) und mit der Turbovakuumpumpe (13), hochdruckseitig, verbindet.

5. Verfahren nach einem der Ansprüche 1 bis 4, **dadurch gekennzeichnet, dass** man den Niederdruckeingang der Schleusenkammer- und Vorvakuumpumpe (9/15) sequentiell vorzugsweise intermittierend mit der Schleusenkammer (1) einerseits, dem Hochdruckausgang der Turbovakuumpumpe (13) anderseits, wirkverbindet (17, 17a, 17b).

6. Verfahren nach einem der Ansprüche 1 bis 5, **dadurch gekennzeichnet, dass** man das Verhältnis des abzupumpenden Volumens der Schleusenkammer (1) zu demjenigen, welches mittels der Turbovakuumpumpe (13) abzupumpen ist, zu höchstens 1:100 wählt.

7. Vakuumbehandlungsanlage, umfassend:
- eine Schleusenkammer (1), damit wirkverbunden eine Schleusenkammerpumpe (9),
- mit der Schleusenkammer (1) kommunizierend, eine Vakuumkammeranordnung (7), mit mindestens einer Turbovakuumpumpe (13) wirkverbunden, welch letzterer, hochdruckseitig, eine Vorvakuumpumpe (15) zugeordnet ist,
**dadurch gekennzeichnet, dass** die der Turbovakuumpumpe (13) zugeordnete Vorvakuumpumpe (15) die Schleusenkammerpumpe (9/15) ist und das Verhältnis des zu pumpenden Schleusenkammervolumens und des mittels der Turbovakuumpumpe (13) zu pumpenden Volumens höchstens 1:40 ist.

8. Anlage nach Anspruch 7, **dadurch gekennzeichnet, dass** die Schleusenkammer- und Vorvakuumpumpe (9/15) eine ein- oder mehrstufige Drehschieberpumpe ist oder eine Membranpumpe.

9. Anlage nach einem der Ansprüche 7 oder 8, **dadurch gekennzeichnet, dass** die Turbovakuumpumpe (13) so ausgelegt ist, dass sie hochdruckseitig gegen einen Druck von mindestens 1 mbar, vorzugsweise von mindestens 10 mbar, arbeiten kann, dass sie vorzugsweise eine Turbo-Drag- bzw. Turbopumpe mit Holweckstufe ist.

10. Anlage nach einem der Ansprüche 7 bis 9, **dadurch gekennzeichnet, dass** der Niederdruckeingang der Schleusenkammer- und Vorvakuumpumpe (9/15) über eine Umschaltanordnung (17, 17a, 17b) einerseits mit der Schleusenkammer (1), anderseits mit dem Hochdruckausgang der Turbovakuumpumpe (13) wirkverbunden ist.

11. Anlage nach einem der Ansprüche 7 bis 10, **dadurch gekennzeichnet, dass** das Verhältnis des zu pumpenden Schleusenkammervolumens und des mittels der Turbovakuumpumpe (13) zu pumpenden Volumens höchstens 1:100 ist.

12. Verwendung des Verfahrens nach einem der Ansprüche 1 bis 6 oder der Anlage nach einem der Ansprüche 7 bis 11 zur Behandlung scheibenförmiger Werkstücke, insbesondere deren Beschichtung, bevorzugt von Datenspeicherscheiben, insbesondere bevorzugt von optischen Datenspeicherscheiben.

13. Verfahren nach einem der Ansprüche 1 bis 6, dabei insbesondere Beschichten von optischen Speicherscheiben, **dadurch gekennzeichnet, dass** die Zykluszeit von Einführen des Werkstückes bis und mit Wegführen höchstens 2 sec. beträgt.

14. Verfahren nach einem der Ansprüche 1 bis 6, 13, **dadurch gekennzeichnet, dass** die Zeitspanne für die Schritte c) bis g) mindestens 50 %, vorzugsweise mindestens 60 %, der Zeitspanne für die Schritte a) bis h) beträgt.

## Claims

1. Process for cyclic vacuum treatment of workpieces in which a workpiece
a) is introduced into a lock chamber (1) open to the atmosphere environment (U),
b) the lock chamber (1) is evacuated after it has been closed (3) against the said environment,
c) the lock chamber is opened into a vacuum chamber arrangement (7) at least a part thereof being evacuated,
d) the workpiece is transported from the lock chamber (1) into the arrangement (7),
e) the workpiece is treated in the arrangement (7),
f) the workpiece is transported back from the arrangement (7) into the lock chamber (1),
g) the lock chamber (1) is closed (5) against the arrangement (7) then flooded (25),
h) the treated workpiece is discharged from the flooded lock chamber (1) into the environment (U),
where:
- at least part of the arrangement (7) is evacuated by means of a turbo vacuum pump (13) with pre-vacuum pump (15) operationally connected thereto on the high pressure side, and
- the lock chamber (1) is evacuated by means of a lock chamber pump (9),
**characterised in that** as a pre-vacuum pump (15), the lock chamber pump (9) is operationally connected with the turbo vacuum pump (13) and the ratio of the lock chamber volume to be evacuated and the volume to be evacuated by means of the turbo vacuum pump (13) at most 1:40.

2. Process according to claim 1, **characterised in that** as a lock chamber pump and pre-vacuum pump (9, 15) a single or multi-stage vane-type rotary pump or a membrane pump is used.

3. Process according to any of claims 1 or 2, **characterised in that** the turbo vacuum pump (13) on the high pressure side can work against a pressure of at least 1 mbar, preferably of at least 10 mbar, and is preferably a turbo drag pump or turbo pump with Holweck stage.

4. Process according to any of claims 1 to 3, **characterised in that** to evacuate the lock chamber (1), on the low pressure side the pre-vacuum pump (9/15) is separated (17, 17a) from its operational connection with the turbo vacuum pump (13), then to evacuate the part of the arrangement the pre-vacuum pump (9/15) is separated (17, 17b) from the lock chamber (1) and is connected with the turbo vacuum pump (13) on the high pressure side.

5. Process according to any of claims 1 to 4, **characterised in that** the low pressure inlet of the lock chamber pump and pre-vacuum pump (9/15) is operationally connected (17, 17a, 17b) sequentially, preferably intermittently, firstly with the lock chamber (1) and secondly with the high pressure outlet of the turbo vacuum pump (13).

6. Process according to any of claims 1 to 5, **characterised in that** the ratio of the lock chamber (1) volume to be evacuated and the volume which is to be evacuated by means of the turbo vacuum pump (13) is selected at most 1:100.

7. Vacuum treatment plant comprising:
- a lock chamber (1) and operationally connected thereto a lock chamber pump (9),
- communicating with the lock chamber (9), a vacuum chamber arrangement (7) operationally connected with at least one turbo vacuum pump (13), where a pre-vacuum pump (15) is allocated to the latter on the high pressure side,
**characterised in that** the pre-vacuum pump (15) allocated to the latter turbo vacuum pump (13) is the lock chamber pump (9/15) and the ratio of the lock chamber volume to be evacuated and the volume to be evacuated by means of the turbo vacuum pump (13) is at most 1:40.

8. Plant according to claim 7, **characterised in that** the lock chamber pump and pre-vacuum pump (9/15) is a single or multi-stage vane-type rotary pump or a membrane pump.

9. Plant according to any of claims 7 or 8, **characterised in that** the turbo vacuum pump (13) is designed so that on the high pressure side it can work against a pressure of at least 1 mbar, preferably of at least 10 mbar, and that it is preferably a turbo drag pump or turbo pump with Holweck stage.

10. Plant according to any of claims 7 to 9, **characterised in that** the low pressure inlet of the lock chamber pump and pre-vacuum pump (9/15) is operationally connected via a switch-over-arrangement (17, 17a, 17b) firstly with the lock chamber (1) and secondly with the high pressure outlet of the turbo vacuum pump (13).

11. Plant according to any of claims 7 to 10, **characterised in that** the ratio of the lock chamber volume to be evacuated and the volume to be evacuated by means of the turbo vacuum pump (13) is at most 1:100.

12. Use of the process according to any of claims 1 to 6 or of the plant according to any of claims 7 to 11 to treat, in particular coat, disc-shaped workpieces, preferably of data storage discs, in particular preferably of optical data storage discs.

13. Process according to any of claims 1 to 6, in particular coating of optical memory discs, **characterised in that** the cycle time from the introduction of the workpiece up to and including their discharge, is at most 2 seconds.

14. Process according to any of claims 1 to 6, 13, **characterised in that** the time span for steps c) to g) is at least 50%, preferably at least 60%, of the time span for steps a) to h).

## Revendications

1. Procédé pour le traitement cyclique sous vide de pièces, selon lequel
a) une pièce est introduite dans un sas (1) ouvert à l'atmosphère ambiante (U),
b) le sas (1) est évacué par pompe après avoir été fermé (3) par rapport à l'environnement,
c) le sas est ouvert sur un dispositif à chambre à vide (7) au moins partiellement évacué par pompe,
d) la pièce passe du sas (1) au dispositif (7),
e) la pièce est traitée dans le dispositif (7),
f) la pièce, à partir du dispositif (7), est ramenée dans le sas (1),
g) le sas (1) est fermé (5) par rapport au dispositif (7), puis est inondé (25),
h) la pièce traitée, à partir du sas (1) inondé, est sortie dans l'environnement (U),
étant précisé
- qu'on évacue par pompe une partie au moins du dispositif (7) à l'aide d'un dépresseur à turbine (13) avec une pompe à vide préliminaire (15) qui est en relation fonctionnelle avec celle-ci, côté haute pression, et
- qu'on évacue le sas (1) à l'aide d'une pompe de sas (9),
**caractérisé en ce que** comme pompe à vide préliminaire (15), on met la pompe de sas (9) en relation fonctionnelle avec le dépresseur à turbine (13), et le rapport du volume de sas à pomper et du volume à pomper à l'aide du dépresseur à turbo (13) est au maximum de 1:40.

2. Procédé selon la revendication 1, **caractérisé en ce qu'**on utilise comme pompe de sas et à vide préliminaire (9/15) une pompe rotative à palettes simple ou multiple, ou une pompe à membrane.

3. Procédé selon la revendication 1 ou 2, **caractérisé en ce que** le dépresseur à turbine (13) peut fonctionner, côté haute pression, à l'encontre d'une pression d'au moins 1 mbar, de préférence d'au moins 10 mbar, et est constituée de préférence par un dépresseur à turbine à étage Holweck.

4. Procédé selon l'une des revendications 1 à 3, **caractérisé en ce que** pour évacuer le sas (1), on supprime (17, 17a), côté basse pression, la relation fonctionnelle entre la pompe à vide préliminaire (9/15) et le dépresseur à turbine (13), puis pour évacuer la partie du dispositif, on sépare (17, 17b) la pompe à vide préliminaire (9/15) du sas (1) et on la relie au dépresseur à turbine (13), côté haute pression.

5. Procédé selon l'une des revendications 1 à 4, **caractérisé en ce qu'**on établit une relation fonctionnelle (17, 17a, 17b) séquentielle, de préférence intermittente, entre l'entrée basse pression de la pompe de sas et à vide préliminaire (9/15) et le sas (1), d'une part, et la sortie haute pression du dépresseur à turbine (13), d'autre part.

6. Procédé selon l'une des revendications 1 à 5, **caractérisé en ce qu'**on choisit pour le rapport du volume du sas (1) à évacuer à celui qui doit être évacué à l'aide du dépresseur à turbine (13), au maximum 1:100.

7. Installation de traitement sous vide comprenant :
- un sas (1) et, relié à celui-ci, une pompe de sas (9),
- un dispositif à chambre à vide (7) qui communique avec le sas (1) et qui est en relation fonctionnelle avec au moins un dépresseur à turbine (13) auquel est associée, côté haute pression, une pompe à vide préliminaire (15),
**caractérisée en ce que** la pompe à vide préliminaire (15) associée au dépresseur à turbine (13) est constituée par la pompe de sas (9/15), et le rapport du volume de sas à pomper et du volume à pomper à l'aide du dépresseur à turbine (13) est au maximum de 1:40.

8. Installation selon la revendication 7, **caractérisée en ce que** la pompe de sas et à vide préliminaire (9/15) est constituée par une pompe rotative à palettes simple ou multiple ou par une pompe à membrane.

9. Installation selon la revendication 7 ou 8, **caractérisé en ce que** le dépresseur à turbine (13) est conçu pour pouvoir fonctionner, côté haute pression, à l'encontre d'une pression d'au moins 1 mbar, de préférence d'au moins 10 mbar, et **en ce qu'**il s'agit de préférence d'un dépresseur à turbine à étage Holweck.

10. Installation selon l'une des revendications 7 à 9, **caractérisée en ce que** l'entrée basse pression de la pompe de sas et à vide préliminaire (9/15) est en relation fonctionnelle, par l'intermédiaire d'un dispositif de commutation (17, 17a), d'une part avec le sas (1) et d'autre part avec la sortie haute pression du dépresseur à turbine (13).

11. Installation selon l'une des revendications 7 à 10, **caractérisée en ce que** le rapport du volume du sas à évacuer à celui qui doit être évacué à l'aide du dépresseur à turbine (13) est au maximum de 1:100.

12. Utilisation du procédé selon l'une des revendications 1 à 6 ou de l'installation selon l'une des revendications 7 à 11 pour traiter et notamment revêtir des pièces en forme de plaques, de préférence des disques de stockage de données et plus spécialement des disques optiques.

13. Procédé selon l'une des revendications 1 à 6, notamment application d'un revêtement sur des disques de stockage optiques, **caractérisé en ce que** la durée du cycle entre l'introduction de la pièce et sa sortie, incluse, est au maximum de 2 s.

14. Procédé selon l'une des revendications 1 à 6, 13, **caractérisé en ce que** la durée des étapes c) à g) représente au moins 50 %, de préférence au moins 60 %, de la durée des étapes a) à h).
